# FASCICULE DE BREVET EUROPEEN

(11) **EP 3 414 536 B1**
(45) Date de publication et mention de la délivrance du brevet: **22.06.2022**
(21) Numéro de dépôt: 17707386.3
(22) Date de dépôt: 07.02.2017
(51) Int. Cl.: G01J 3/10

(54) **COMPOSANT ELECTRONIQUE A RESISTANCE METALLIQUE SUSPENDUE DANS UNE CAVITE FERMEE**
ELEKTRONISCHE KOMPONENTE MIT EINEM METALLISCHEN, IN EINEM GESCHLOSSENEN HOHLRAUM AUFGEHÄNGTEN WIDERSTAND
ELECTRONIC COMPONENT WITH A METAL RESISTOR SUSPENDED IN A CLOSED CAVITY

(30) Priorité: 12.02.2016 FR 1651129
(43) Date de publication de la demande: 19.12.2018
(73) Titulaire: Commissariat à l'Energie Atomique et aux Energies Alternatives, 75015 Paris (FR)
(72) Inventeur: NICOLETTI, Sergio, 38650 Sinard (FR); BRUN, Mickaël, 38320 Eybens (FR)
(74) Mandataire: INNOV-GROUP
(86) Numéro de dépôt international: PCT/FR2017/050278
(87) Numéro de publication internationale: WO 2017/137694

(56) Documents cités:
- WO-A1-98/43281
- WO-A1-2006/031125
- US-A- 5 668 033
- US-A1- 2003 041 649
- Anonymous: "Eutectic bonding - Wikipedia", , 24 mai 2015 (2015-05-24), XP055311433, Extrait de l'Internet: URL:https://en.wikipedia.org/w/index.php?t itle=Eutectic_bonding&oldid=663769249 [extrait le 2016-10-17]
- PIERRE BARRITAULT ET AL: "Mid-IR source based on a free-standing microhotplate for autonomous COsensing in indoor applications", SENSORS AND ACTUATORS A: PHYSICAL, ELSEVIER BV, NL, vol. 172, no. 2, 21 septembre 2011 (2011-09-21), pages 379-385, XP028336715, ISSN: 0924-4247, DOI: 10.1016/J.SNA.2011.09.027 [extrait le 2011-10-10] cité dans la demande

## Description

### Domaine de l'Invention

La présente invention concerne le domaine de la génération de rayonnements infrarouges, en particulier dans le domaine de la détection de gaz.

### Etat de la technique

Dans le domaine de la détection des gaz, il est connu d'utiliser un capteur infrarouge non-dispersif. Un tel capteur infrarouge non-dispersif est aussi connu sous la dénomination NDIR acronyme anglais de « NonDispersive InfraRed ».

Un tel capteur infrarouge comporte une source infrarouge - aussi appelée composant électronique - pour générer un rayonnement infrarouge dans la suite de la description. Dans la littérature, il a déjà été utilisé des sources à base de filament déposé sur du silicium ou suspendu. Le document « Sensors and Actuators A : Physical » dans l'article dont le titre est « Mid-IR source based on a free-standing microhotplate for autonomous CO2 sensing in indoor applications » de P. Barritault et al. Publié dans « Sensors and Actuators A 172 (2011) 379 - 385 » décrit notamment une façon de former une source en utilisant un élément résistif métallique suspendu par des bras au-dessus d'une cavité ouverte. La source décrite dans ce document permet d'émettre un rayonnement infrarouge en limitant la consommation en termes de puissance de la source pour atteindre une température de travail adéquate.

Une source telle que décrite dans le document ci-dessus est adéquate lorsque l'on dispose d'assez de puissance optique. Il existe cependant à ce jour un besoin d'encore diminuer la puissance électrique nécessaire pour le fonctionnement de la source infrarouge.

Le document US2003/0041649 décrit quant à lui un dispositif muni d'une cavité formée par le montage de trois éléments indépendants et collés deux à deux, notamment par soudure eutectique. L'industrialisation d'un tel dispositif est difficile du fait des pièces à manipuler, ce qui peut poser problème en augmentant par ailleurs les risques de fuites entre l'intérieur de la cavité et l'extérieur de la cavité.

Par ailleurs, un autre besoin est de conserver une source de petite taille et industrialisable à des cadences et des coûts convenables.

### Objet de l'invention

L'invention a pour but de tendre à la résolution d'au moins une partie des problématiques évoquées ci-dessus.

On tend vers ce but grâce à un composant électronique pour générer un rayonnement infrarouge, ledit composant électronique comprenant un premier élément et un deuxième élément agencés de sorte à former une cavité fermée et sous vide dans laquelle au moins un élément résistif dudit composant électronique est suspendu, ledit au moins un élément résistif comprenant du métal, lesdits premier et deuxième éléments étant liés par soudure eutectique permettant de fermer de façon étanche la cavité, ledit composant électronique comportant des bornes de connexion situées à l'extérieur de la cavité fermée et reliées électriquement à l'élément résistif suspendu.

Notamment, la soudure eutectique est réalisée avec du silicium et de l'or, ou Cu et Sn, ou Au et Sn, ou Au et Ge, ou Al et Ge, ou Au et In.

Selon l'invention la cavité fermée présente une pression interne inférieure à 10⁻² mbar, et notamment comprise entre 10⁻³ mbar et 10⁻² mbar.

Notamment, un piège à gaz résiduels est situé dans la cavité fermée.

L'élément résistif est suspendu par des bras de suspension appartenant au premier élément.

Selon un premier cas, le premier élément comporte les bornes de connexion.

Selon un deuxième cas, le deuxième élément comporte les bornes de connexion, le premier élément comporte des plots de connexion reliés électriquement à l'élément résistif, les bornes de connexion étant chacune en contact électrique avec au moins un des plots de connexion.

Selon une mise en œuvre, l'élément résistif comporte au moins une partie structurée d'un empilement comprenant les couches successives suivantes : une première couche barrière à la diffusion d'une couche en métal, la couche en métal notamment en platine, une deuxième couche barrière à la diffusion de la couche en métal, préférentiellement les première et deuxième couches barrières sont en nitrure de titane.

En outre, ledit empilement peut former une partie des bras de suspension de l'élément résistif et s'étend en direction des bornes de connexion.

De préférence, la fermeture de la cavité fermée est assurée par un unique cordon de soudure eutectique.

En particulier, la cavité fermée est délimitée au moins en partie par un creux formé dans le premier élément, ledit creux comportant un fond orienté vers l'élément résistif, ledit creux étant délimité par une surface continue d'un même matériau.

L'invention est aussi relative à un procédé de fabrication d'une pluralité de composants électroniques tels que décrits, dans ce cas, le procédé comporte les étapes suivantes : une étape de fourniture d'une première plaque comprenant une base, préférentiellement en silicium, au niveau de laquelle est formée une pluralité de premiers creux, ladite première plaque comprenant des éléments résistifs suspendus comprenant du métal, et chaque premier creux est associé à au moins un des éléments résistifs suspendus et disposé en regard du fond dudit premier creux ; une étape de fourniture d'une deuxième plaque, préférentiellement formée en tout ou partie par du silicium, comportant des deuxièmes creux destinés à coopérer avec lesdits premiers creux en vue de former les cavités fermées des composants électroniques ; une étape d'assemblage des première et deuxième plaques comportant une étape de soudage eutectique mise en œuvre dans une enceinte sous vide d'où il résulte : une formation des cavités fermées, sous vide, et étanches, et une localisation de bornes de connexion des éléments résistifs dans des espaces creux délimités par les première et deuxième plaques et formés à l'extérieur des cavités fermées ; une étape d'enlèvement de matière au niveau des espaces creux pour rendre les bornes de connexion accessibles.

Par ailleurs, le procédé peut aussi comporter une étape de séparation des composants électroniques par enlèvement de matière.

Notamment, l'étape de soudage eutectique utilise de l'or et du silicium, ou Cu et Sn, ou Au et Sn, ou Au et Ge, ou Al et Ge, ou Au et In, mis en contact.

Selon une réalisation, le procédé comporte au préalable de l'étape d'assemblage, pour chaque premier creux, une étape de formation d'une piste fermée en un premier matériau, préférentiellement de l'or, agencée à la périphérie dudit premier creux, et la deuxième plaque comporte des portées d'appui en un deuxième matériau, préférentiellement du silicium, disposées chacune en contact contre la piste correspondante lors de l'étape d'assemblage, l'étape de soudage eutectique comportant une étape de sollicitation des première et deuxième plaques l'une vers l'autre en appliquant une température adaptée pour former la soudure eutectique à partir des premier et deuxième matériaux.

Selon un cas, la première plaque comporte les bornes de connexion, et l'étape d'enlèvement de matière est mise en œuvre par enlèvement de matière appartenant à la deuxième plaque.

Notamment, selon ce cas, l'étape d'enlèvement de matière peut être mise mise en œuvre par une des techniques choisies parmi : un sciage, un polissage, une gravure.

Par ailleurs, selon ce cas l'étape de séparation peut comporter l'enlèvement de matière appartenant à la première plaque, notamment par sciage.

Selon un autre cas, le procédé est tel que : les bornes de connexion sont portées par la deuxième plaque ; la première plaque comporte des plots de connexion chacun relié électriquement à au moins un élément résistif, et des troisièmes creux destinés à former les espaces creux ; il résulte de l'étape d'assemblage une mise en contact électrique des plots de connexion avec les bornes de connexion correspondantes et une formation des espaces creux comprenant les bornes de connexion.

Notamment selon cet autre cas, l'étape d'enlèvement de matière est mise en œuvre par enlèvement de matière appartenant à la première plaque au niveau des espaces creux.

Par ailleurs, selon cet autre cas, l'étape d'enlèvement de matière de la première plaque peut être mise en œuvre par une des techniques choisies parmi : un sciage, un polissage, une gravure.

Enfin selon cet autre cas, l'étape de séparation comporte l'enlèvement de matière appartenant à la deuxième plaque, notamment par sciage.

L'invention est aussi relative à une utilisation d'un composant électronique tel que décrit en tant que source de rayonnement infrarouge pour la détection de gaz.

L'invention est aussi relative à un détecteur de gaz comprenant un composant électronique tel que décrit et un capteur apte à mesurer un rayonnement infrarouge issu du composant électronique.

### Description sommaire des figures

L'invention sera mieux comprise à la lecture de la description qui va suivre, donnée uniquement à titre d'exemple non limitatif et faite en se référant aux dessins sur lesquels :
- la figure 1 illustre un composant électronique selon un mode d'exécution de l'invention,
- la figure 2 illustre un composant électronique selon un autre mode d'exécution de l'invention,
- la figure 3 illustre schématiquement une partie du composant électronique qui est suspendue dans la cavité,
- les figures 4 à 7 illustrent différentes étapes d'un procédé permettant la fabrication d'une pluralité de composants électroniques du type de la figure 1,
- les figures 8 à 11 illustrent différentes étapes d'un procédé permettant la fabrication d'une pluralité de composants électroniques du type de la figure 2,
- les figures 12 et 13 illustrent quant à elles deux variantes d'une étape respectivement des deux procédés évoqués ci-dessus,
- les figures 14 à 21 illustrent une manière de former un élément résistif suspendu du type utilisé dans la présente invention, selon les figures 14 à 19 il s'agit d'une coupe n'incluant pas les bras de suspension, les figures 20 et 21 représentent au contraire une coupe incluant les bras de suspension,
- la figure 22 illustre schématiquement un détecteur à gaz comprenant un composant électronique selon l'invention.

Dans ces figures, les mêmes références sont utilisées pour désigner les mêmes éléments.

Par ailleurs, les éléments représentés sur les figures ne sont pas à l'échelle.

### Description de modes particuliers de réalisation

Le composant électronique décrit ci-après diffère de l'art antérieur en ce que l'élément résistif est encapsulé sous vide et de manière étanche dans une cavité fermée. La mise sous vide permet d'éviter la conduction thermique du rayonnement infrarouge émis par l'élément résistif avec des gaz en contact avec ledit élément résistif permettant notamment de limiter la consommation électrique. Cette solution induit une problématique de fermeture de la cavité et d'étanchéité de cette dernière. Pour l'obtention de la cavité fermée, il est ici proposé d'utiliser une soudure entre deux éléments (notamment un support et un capot) ne dégradant pas le composant électronique, notamment lorsque ce dernier comporte des contacts électriques (bornes et/ou plots de connexion) ou encore un piège à gaz de type Getter. C'est en ce sens que la solution proposée pour la fermeture de la cavité s'accompagne d'une soudure à basse température de type soudure eutectique, notamment entre de l'or et du silicium. Outre la résolution de la problématique de dégradation, une soudure eutectique permet de répondre en synergie à la problématique d'étanchéité de la cavité et d'industrialisation à des cadences et des coûts convenables. Dans la présente application, le composant électronique pourra être utilisé en chauffant l'élément résistif à une température supérieure à 200°C afin d'émettre un rayonnement infrarouge dans la gamme 3µm à 5µm.

Dans la présente description, lorsque les termes « de l'ordre de » sont utilisés en combinaison avec une valeur, on entend la valeur exacte ou la valeur donnée à plus ou moins 10%.

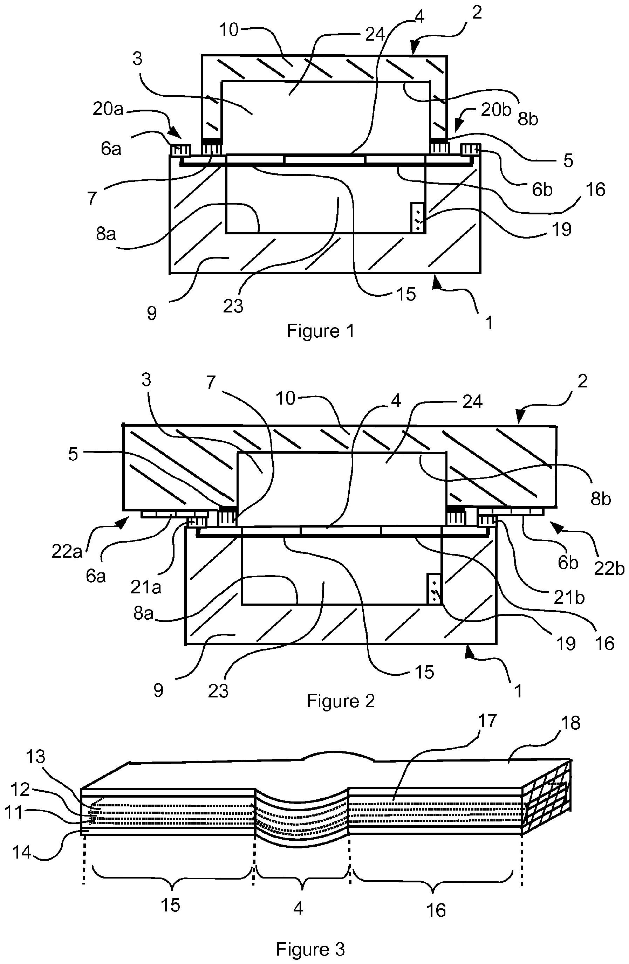

Les figures 1 et 2 illustrent une vue en coupe schématique d'un composant électronique selon deux modes d'exécution différents de l'invention. De manière générale, le composant électronique pour générer un rayonnement infrarouge comprend un premier élément 1 et un deuxième élément 2 agencés de sorte à former une cavité fermée 3 et sous vide dans laquelle au moins un élément résistif 4 dudit composant électronique est suspendu. On comprend alors qu'il peut y avoir plusieurs éléments résistifs dans une même cavité fermée 3, tout ce qui s'applique dans la présente description pour un élément résistif 4 par cavité 3 peut donc être mis en œuvre pour plusieurs éléments résistifs 4 par cavité 3 ou au moins un élément résistif 4. L'élément résistif est un élément résistif électriquement apte à chauffer et à émettre le rayonnement infrarouge. L'élément résistif 4 comprend du métal, en particulier du platine. Par « élément résistif qui comprend du métal », on entend que l'élément résistif comporte au moins une couche métallique qui est structurée pour former une résistance électrique. La température opérationnelle de l'élément résistif 4 peut être de maximum 650°C, mais toute température entre la température ambiante et la température maximum peut être autorisée, cela dit, en dessous de 300°C-350°C la puissance optique est moindre. Lesdits premier et deuxième éléments 1, 2 sont liés par soudure eutectique 5 permettant de fermer de façon étanche la cavité 3. En outre, le composant électronique comporte des bornes de connexion 6a, 6b situées à l'extérieur de la cavité 3 et reliées électriquement à l'élément résistif suspendu 4.

Par soudure eutectique, on entend la présence d'un alliage eutectique, notamment formé par de l'or et du silicium, et en particulier obtenu par thermocompression. La soudure eutectique peut aussi être obtenue/réalisée avec les matériaux suivants Cu et Sn, ou Au et Sn, Au et Ge, Al et Ge, ou Au et In. Autrement dit, la soudure eutectique 5 est le résultat d'une étape de soudage eutectique (aussi connue dans le domaine sous les terminologies anglaises « Eutectic bonding » ou « Eutectic soldering ») d'où il résulte la formation d'un alliage à partir d'un premier matériau et d'un deuxième matériau différent du premier matériau, en particulier d'or et de silicium. Les matériaux Au et Si, ou Au et Ge, ou Al et Ge sont préférés. Pour cela, le premier élément 1 peut comporter une piste fermée en un premier matériau (notamment de l'or) 7 et le deuxième élément 2 peut être formé en, ou comporter le, deuxième matériau (notamment du silicium), la soudure eutectique 5 (par exemple l'alliage SiAu) est alors formée au niveau de l'interface entre le deuxième élément 2 et le premier élément 1. Selon les cas, le deuxième élément 2 peut aussi comporter une piste additionnelle de telle sorte que la piste 7 et la piste additionnelle soient reliées par un alliage eutectique issu du matériau de la piste 7 et de la piste additionnelle. Par étude du composant électronique, notamment au niveau de l'interface entre les premier et deuxième éléments 1, 2, il est possible de savoir si la liaison entre ces derniers est bien obtenue par soudage eutectique ou non puisque la soudure possède alors des caractéristiques particulières et identifiables, il est par exemple possible de savoir si le silicium a bien migré dans l'or. L'avantage d'une telle soudure eutectique est qu'elle peut être réalisée à basse température. Par basse température, on entend préférentiellement une température comprise entre 350°C et 400°C, et préférentiellement égale à 350°C qui permet notamment d'éviter la fusion de la ou des couches formant notamment les bornes de connexion 6a, 6b et l'éventuel piège à gaz qui sera décrit ci-après. De manière générale, dans la suite de la description, il est fait référence à l'alliage or- silicium en tant que soudure eutectique, bien entendu les alliages de matériaux visés ci-dessus (Au et In, ou Cu et Sn, ou Au et Sn, Au et Ge, Al et Ge) peuvent être utilisés en substitution de SiAu. L'homme du métier sera donc à même d'adapter la structure du composant électronique et le procédé permettant de fermer la cavité par soudage en vue de former une soudure eutectique selon les différentes possibilités de matériaux.

Les bornes de connexion 6a, 6b (bien entendu électriquement conductrices) permettent d'alimenter électriquement l'élément résistif 4 depuis l'extérieur de la cavité fermée 3 de manière à ce que ce dernier monte en température et provoque l'émission du rayonnement infrarouge désiré. Ces bornes de connexion 6a, 6b, et le cas échéant les plots de connexion décrits ci-après, comportent préférentiellement de l'or ou de l'aluminium.

Le composant électronique est notamment configuré de telle sorte que le rayonnement infrarouge émis par l'élément résistif 4 lorsque ce dernier est alimenté électriquement soit diffusé à l'extérieur de la cavité 3. Pour cela, la cavité fermée 3 peut être délimitée au moins en partie par des parois 8a, 8b transparentes dans l'infrarouge, de préférence en silicium, notamment en silicium mono ou poly cristallin ou en tout autre matériau transparent dans l'infrarouge. Par transparent aux infrarouges, on entend que les matériaux utilisés peuvent autoriser une transmissivité dans l'infrarouge de l'ordre de 50% à 60%, notamment lorsqu'il n'est pas utilisé de revêtement antireflet. Par autre matériau transparent à l'infrarouge on entend par exemple du germanium, de l'AlGaS, du GaS, ou de l'InP. Autrement dit, pour autoriser le passage du rayonnement infrarouge émis par l'élément résistif 4 de l'intérieur de la cavité fermée 3 vers l'extérieur de cette dernière, les premier et deuxième éléments 1, 2 comportent respectivement des parties 9, 10 en silicium - ou dans l'un ou plusieurs des autres matériaux transparents visés précédemment. En cas de silicium utilisé pour sa transparence aux infrarouges, il est utilisé du silicium mono ou poly cristallin. Plus particulièrement, le premier élément 1 comporte un substrat 9 en silicium (notamment mono ou poly cristallin) et le deuxième élément 2 comporte un capot 10 en silicium (notamment mono ou poly cristallin).

Pour autoriser la présence des bornes de connexion 6a, 6b à l'extérieur de la cavité fermée 3, le premier élément 1 peut comporter différentes couches empilées (en particulier à partir du substrat 9) permettant cette fonction, notamment, il peut être utilisé au moins une couche en métal disposée entre des couches électriquement isolantes.

De manière générale, le premier élément 1 peut être obtenu à la manière du - et donc comporter les caractéristiques du - composant électronique décrit dans « Sensors and Actuators A : Physical » dans l'article dont le titre est « Mid-IR source based on a free-standing microhotplate for autonomous CO2 sensing in indoor applications » de P. Barritault et al. Publié dans « Sensors and Actuators A 172 (2011) 379 - 385 ». C'est sur ce premier élément 1 qu'il peut alors être rajouté une piste fermée 7, en particulier en or, destinée à former un alliage eutectique (notamment en or/silicium) grâce à l'utilisation du deuxième élément 2 (notamment en silicium).

Plus précisément, l'élément résistif 4 peut comporter, comme illustré en figure 3 au moins une partie structurée d'un empilement de couches comportant les couches successives suivantes : une couche en nitrure de titane 11 (d'épaisseur préférentiellement comprise entre 10nm et 100nm), une couche en platine 12 (d'épaisseur préférentiellement comprise entre 10nm et 100nm), une autre couche en nitrure de titane 13 (d'épaisseur préférentiellement comprise entre 10nm et 100nm). Plus généralement, la couche en platine 12 est une couche en métal formant la résistance électrique de l'élément résistif, et les couches en nitrure de titane 11, 13 forment plus généralement des première et deuxième couches barrières à la diffusion de la couche en métal 12 (en particulier en platine).

Cet empilement de couches peut s'étendre à partir d'une couche 14 de relaxation des contraintes, en particulier en Si₃N₄ et notamment d'épaisseur préférentiellement comprise entre 100nm et 500nm, formant d'une part une base de support de l'élément résistif 4, et d'autre part une base de support de bras de suspension 15, 16 (figures 1 et 2) de l'élément résistif 4. Ces bras de suspension 15, 16 sont préférentiellement ancrés au substrat en silicium 9 du premier élément 1 décrit ci-avant en particulier par un contact de la couche de relaxation 14 avec ledit substrat 9. Autrement dit, l'élément résistif 4 peut être suspendu par des bras de suspension 15, 16 appartenant au premier élément 1. Les bras de suspension 15, 16 sont préférentiellement ancrés au support, ou substrat 9, par liaison d'atomes issus d'une couche déposée sur le support ou substrat 9.

L'avantage de l'utilisation du platine évoqué précédemment pour former une partie de l'élément résistif 4 est que ce matériau est un bon candidat pour former un élément résistif chauffant puisqu'il est stable mécaniquement, chimiquement et électriquement à haute température. Les couches en nitrure de titane 11, 13 permettent de :
- former une bonne couche d'accroché sur des couches contenant du silicium comme le Si₃N₄,
- former une barrière de diffusion du platine pour limiter la dérive thermique lors de la montée en température de l'élément résistif,
- il s'agit d'un bon émetteur de radiation, donc compatible avec l'émission de photons notamment dans la bande spectrale infrarouge : il permet donc de maximiser l'émission.

Comme l'illustre la figure 3, l'empilement de couches décrit ci-avant forme au moins une partie des bras de suspension 15, 16 de l'élément résistif 4 et s'étend en direction des bornes de connexion 6a, 6b (notamment de part et d'autre de l'élément résistif 4). Autrement dit, des parties de cet empilement, distinctes de la partie associée à l'élément résistif 4, permettent donc de former des liaisons électriques entre l'élément résistif 4 et les bornes de connexion 6a, 6b. On comprend que la figure 3 représente schématiquement l'élément résistif 4 et les bras de suspension 15, 16 disposés dans la cavité 3. Ces bras de suspension s'étendent par ailleurs aussi en dehors de la cavité fermée pour s'ancrer sur le substrat 9 et former des zones de reprise de contacts qui pourront être liées électriquement aux bornes de connexion 6a, 6b ou à des plots de connexion 21a, 21b comme il sera vu plus tard. Bien que cela ne soit pas représenté, on note que la structure peut inclure des bras additionnels sans liens électriques mais uniquement présents pour donner une stabilité mécanique à l'élément résistif 4. Ces bras additionnels peuvent, par exemple, relier l'élément résistif à la paroi de la cavité sans altérer le fonctionnement de l'élément résistif 4.

L'empilement de couches pourra en outre être recouvert d'une couche de SiO₂, notamment d'épaisseur comprise entre 50nm et 500nm, servant de couche de passivation 17 elle-même couverte d'une couche de Si₃N₄ 18, notamment d'épaisseur comprise entre 100nm et 500nm, permettant de former une autre couche de relaxation des contraintes. En particulier, la couche de passivation 17 recouvre les flancs latéraux des couches 11, 12 et 13 ainsi que le dessus de ces couches (c'est-à-dire le dessus de l'empilement), hormis une zone de reprise de contact pour les bornes de connexion. C'est en ce sens que les couches 11, 12, 13 de la figure 3 sont représentées en pointillés car « enterrées » dans la couche de passivation.

La piste 7, préférentiellement en or, dont au moins une partie a servi à former l'eutectique visé ci-avant repose préférentiellement sur une couche de Si₃N₄ qui entoure la cavité fermée 3.

De manière générale, la cavité fermée 3 présente une pression interne inférieure à 10⁻² mbar (soit 1 pascal) et notamment comprise entre 10⁻³ mbar (soit 0,1 pascal) et 10⁻² mbar. On comprend donc que l'étanchéité de la cavité 3 est telle que cette pression est maintenue dans la cavité 3 au cours du temps. Notamment, cette pression interne définit le vide de la cavité 3.

Il résulte de la fabrication d'un tel composant électronique, qu'avec le temps, des molécules emprisonnées dans les matériaux au niveau des parois de la cavité fermée 3 peuvent se diffuser dans la cavité fermée 3. La présence de telles molécules dans la cavité fermée 3 est néfaste au bon fonctionnement du composant électronique dans le sens où elles risquent d'augmenter la puissance consommée pour atteindre la température de travail de l'élément résistif 4. Pour résoudre cette problématique, il est proposé d'intégrer un piège à gaz 19 (figures 1 et 2) au composant électronique. Autrement dit, le composant électronique comporte un piège 19 à gaz résiduels situé dans la cavité fermée 3. Un tel piège à gaz 19 est aussi connu dans le domaine sous la dénomination anglaise de « Getter ». Le piège à gaz 19 permet d'absorber les molécules afin que ces dernières ne viennent pas perturber la montée en température de l'élément résistif 4 et permet de maintenir la pression visée ci-dessus dans la cavité fermée 3. Le piège à gaz est préférentiellement placé à distance de l'élément résistif 4 et des bras de suspension 15, 16 le portant. Un autre avantage de l'utilisation d'une soudure eutectique 5, notamment entre de l'or et du silicium, est que cette dernière permet, à la vue des températures mises en œuvre pour la réaliser, d'activer le Getter présent au sein de la cavité fermée 3 sans le dégrader au moment où l'on scelle la cavité. En effet, le piège à gaz peut se dégrader lorsqu'il atteint des températures supérieures à 400°C : il en résulte que l'utilisation d'une soudure eutectique est particulièrement compatible avec un tel piège à gaz. On comprend alors que l'homme du métier sait choisir un piège à gaz adapté à la réalisation du composant électronique. En particulier, le piège à gaz choisi est du type à s'activer à la température de soudage eutectique mais sans se dégrader à cette température de soudage. Par exemple, le piège à gaz peut comporter un mélange de métaux incluant du titane.

Selon un exemple particulier, l'élément résistif 4 présente un diamètre de l'ordre de 150µm à 250µm, et une hauteur maximale comprise entre 100nm et 1000 nm et plus particulièrement égale à 300nm. Les bras de suspension 15, 16 portant cet élément résistif 4 et reliant l'élément résistif 4 aux parois internes de la cavité fermée présentent une dimension latérale comprise entre 10 µm et 100 µm et notamment égale à 40µm, une hauteur maximale comprise entre 100 nm et 1000 nm et plus particulièrement égale à 300nm, et une longueur entre la paroi interne de la cavité fermée 3 et l'élément résistif comprise entre 300 µm et 1000 µm et notamment égale à 350µm.

Les dimensions internes de la cavité fermée 3 sont notamment choisies pour éviter que l'élément résistif 4 et/ou les bras de suspension 15, 16 de l'élément résistif 4 viennent en contact contre une face interne de la cavité 3 en cas de mouvement de l'élément résistif 4 au sein de la cavité 3 notamment provoqué par des dilatations thermiques. En effet, un tel contact pourrait détériorer de manière définitive le composant électronique par effet de collage de l'élément résistif 4 et/ou des bras de suspension 15, 16 contre ladite face interne de la cavité 3. C'est en ce sens que dans une configuration normale de l'élément résistif 4 au sein de la cavité 3, ce dernier est séparé des parois de la cavité 3 d'une distance d'au moins 5 µm et notamment comprise entre 10µm et 100µm. En particulier, en considérant un plan d'inclusion de l'élément résistif 4, deux faces opposées interne de la cavité 3 sont incluses respectivement dans des premier et deuxième plans parallèles audit plan d'inclusion. Ici, les distances minimales de séparation de chacune des deux faces opposées internes par rapport à l'élément résistif peuvent être de l'ordre de 80 µm et notamment comprises entre 50µm et 80µm. En fait, le composant électronique peut être tel que le premier élément 1 comporte un premier creux 23 et que le deuxième élément 2 comporte un deuxième creux 24 qui en coopération avec le premier creux 23 vient former la cavité fermée 3 (figures 1 et 2). Le premier creux 23 peut comporter une profondeur comprise entre 50µm et 100µm et notamment égale à 80µm. La profondeur du premier creux 23 est notamment telle qu'elle résulte d'une gravure anisotrope du substrat en silicium (dans ce cas le substrat en silicium est du silicium monocristallin) en dessous de l'élément résistif 4 lors de la fabrication du premier élément 1. Le deuxième creux 24 peut comporter une profondeur comprise entre 5µm et 300µm et notamment égale à 80µm. Par ailleurs, les premier et deuxième creux 23, 24 peuvent présenter des dimensions latérales comprises entre 300 µm et 1000µm et notamment égales à 350 µm. Il en résulte que, de manière générale, la cavité fermée 3 peut présenter un volume compris entre 1×10⁻⁶ cm³et 1×10⁻⁴ cm³et notamment égal à 2×10⁻⁵ cm³.

Ainsi, un creux (par exemple le premier creux ou le deuxième creux) peut être une partie concave, ou une dépression, agencée dans l'élément concerné. Le creux comporte un fond et une ouverture permettant l'accès au volume du creux. Un creux forme alors un évidement dans une pièce, ici par exemple dans l'élément concerné. L'ouverture et le fond du creux sont reliés par une paroi latérale du creux. Une paroi latérale du creux peut comporter une ou plusieurs faces. Un creux est alors assimilé à un trou borgne, c'est-à-dire que le creux est non traversant.

La cavité fermée 3 peut être délimitée au moins en partie par un creux 23 formé dans le premier élément 1, ledit creux 23 comportant un fond orienté vers l'élément résistif 4, ledit creux 23 étant délimité par une surface continue d'un même matériau, par exemple du silicium. Le creux 23 formé dans le premier élément 1 est aussi appelé premier creux 23 dans le sens où la cavité 3 peut aussi être délimitée au moins en partie par un deuxième creux 24 formé dans le deuxième élément 2, ledit deuxième creux 24 comportant un fond orienté vers l'élément résistif 4, et ledit deuxième creux 24 étant délimité par une surface continue d'un même matériau, par exemple du silicium. En particulier, le premier creux 23 comporte un fond et une paroi latérale formés par une surface continue en un même matériau par exemple en silicium, et le deuxième creux 24 comporte un fond et une paroi latérale formés par une surface continue en un même matériau par exemple en silicium.

On comprend alors que le premier élément 1 peut comporter le premier creux 23 et que l'élément résistif 4 s'étend au moins en partie en regard du fond du premier creux 23. Ainsi, la coopération du premier creux 23 du premier élément 1 avec le deuxième élément 2 alors soudé par soudure eutectique au premier élément 1 permet de former la cavité fermée 3. Vis-à-vis de la réalisation du document US2003/0041649, on propose ici d'utiliser deux éléments munis de creux et une seule soudure eutectique pour fermer la cavité fermée 3. Il en résulte que l'industrialisation est plus aisée et que l'on limite les probabilités de fuites du fait de l'utilisation d'une unique soudure eutectique.

Selon une réalisation, le premier élément 1 comporte une base, ou substrat 9, monobloc, le premier creux 23 est formé dans cette base, notamment sous l'élément résistif 4, un fond du premier creux 23 étant orienté vers l'élément résistif 4. Le deuxième creux 24 peut être formé au sein du deuxième élément 2, notamment dans au moins une partie de ce dernier.

De préférence, on comprend que dans le cadre du composant électronique la fermeture de la cavité fermée 3 peut être assurée par un unique cordon de soudure eutectique en vue de limiter les possibilités de fuites entre l'intérieur de la cavité 3 et l'extérieur de la cavité fermée 3.

Dans un premier cas illustré en figure 1, c'est le premier élément 1 qui comporte les bornes de connexion 6a, 6b. Comme on peut le constater, l'assemblage du premier élément 1 avec le deuxième élément 2 permet de conserver deux portions 20a, 20b du premier élément 1 situées au niveau d'une même face dudit premier élément 1 et qui s'étendent depuis une zone d'interface entre le premier élément 1 et le deuxième élément 2 dans des directions opposées de part et d'autre dudit deuxième élément 2. Les bornes de connexion 6a, 6b s'étendent de ces portions 20a, 20b.

Dans un deuxième cas illustré en figure 2, c'est le deuxième élément 2 qui comporte les bornes de connexion 6a, 6b. Dans ce cas, le premier élément 1 comporte des plots de connexion 21a, 21b (bien entendu électriquement conducteurs) disposés à l'extérieur de la cavité fermée 3 et reliés électriquement à l'élément résistif 4. Par ailleurs, chacune des bornes de connexion 6a, 6b est en contact électrique avec au moins un des plots de connexion 21a, 21b. Comme on peut le constater, l'assemblage du premier élément 1 avec le deuxième élément 2 permet de conserver deux portions 22a, 22b du deuxième élément 2 situées au niveau d'une même face dudit deuxième élément 2 et qui s'étendent depuis une zone d'interface entre le premier élément 1 et le deuxième élément 2 dans des directions opposées de part et d'autre dudit premier élément 1. Dès lors, chaque borne de connexion 6a, 6b comporte une zone de contact électrique avec un plot de connexion 21a, 21b associé qui n'est donc pas accessible et une zone accessible au niveau d'une portion 22a, 22b correspondante destinée à la reprise de contact pour alimenter l'élément résistif 4 depuis l'extérieur de la cavité 3.

On comprend alors que les premier et deuxième cas se distinguent dans le fait qu'ils proposent de présenter les bornes de connexions 6a, 6b au niveau de deux faces opposées (faces arrière et avant) du composant électronique. Le cas pourra donc être choisi entre le premier cas et le deuxième cas en fonction des contraintes d'intégration du composant électronique.

L'invention est bien entendue aussi relative à un procédé de fabrication d'une pluralité de composants électroniques tels que décrits. Ce procédé propose notamment de former les cavités des composants électroniques à basse température pour les raisons évoquées précédemment.

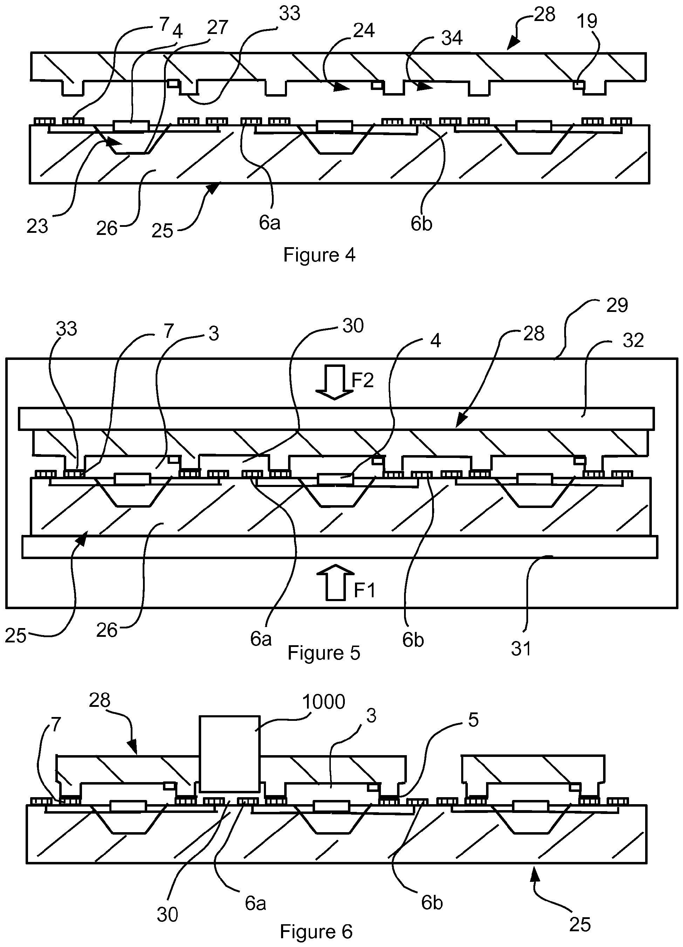

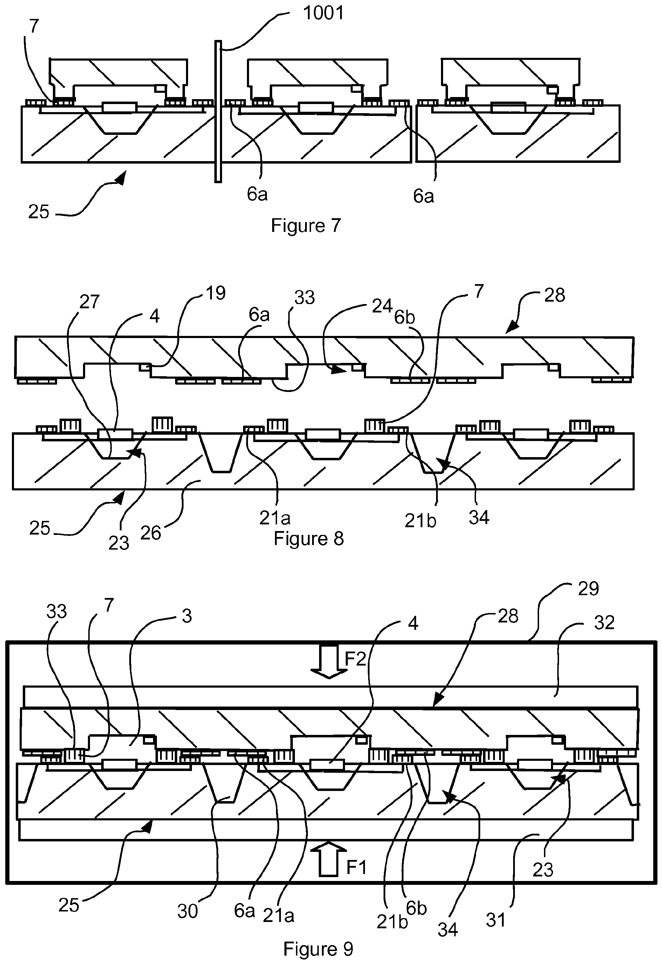

En ce sens, comme illustré aux figures 4 à 13, le procédé de fabrication de la pluralité de composants électroniques tels que décrits comporte une étape de fourniture (figures 4 et 8) d'une première plaque 25 comprenant une base 26, préférentiellement en silicium (ou plaque, ou wafer, en silicium), au niveau de (c'est-à-dire notamment dans) laquelle est formée une pluralité de premiers creux 23. La base 26 peut donc comporter les premiers creux 23. Les creux 23 de la pluralité de premiers creux sont donc formés dans la plaque 25, notamment dans la base 26 de la première plaque 25. La base 26 est préférentiellement dans un matériau transparent aux infrarouges. En ce sens, la base 26 est préférentiellement en silicium, notamment mono ou poly cristallin, car elle est ainsi transparente aux infrarouges, mais un autre matériau aussi transparent aux infrarouges tel que donné précédemment peut aussi être utilisé. Ladite première plaque 25 comprend des éléments résistifs suspendus 4 comprenant du métal, et chaque premier creux 23 est associé à au moins un des éléments résistifs suspendus 4 et disposé en regard du fond 27 dudit premier creux 23. Ce fond 27 du premier creux est notamment délimité par une surface de la base 26. Il en résulte qu'il est donc nécessaire de fermer les premiers creux 23 pour former les cavités 3 souhaitées de chacun des composants électroniques. Pour cela, le procédé comporte une étape de fourniture d'une deuxième plaque 28 (figures 4 et 8) comportant des deuxièmes creux 24 destinés à coopérer avec lesdits premiers creux 23 en vue de former les cavités fermées des composants électroniques. Cette deuxième plaque 28 est préférentiellement formée en tout ou partie par du silicium (notamment mono ou poly cristallin), car elle est ainsi transparente aux infrarouges, mais un autre matériau aussi transparent aux infrarouges tel que décrit ci-avant peut aussi être utilisé. La deuxième plaque 28 peut alors être un wafer. Ensuite, le procédé comporte une étape d'assemblage (figures 5 et 9) des première et deuxième plaques 25, 28 comportant une étape de soudage eutectique mise en œuvre dans une enceinte 29 sous vide d'où il résulte :
∘ une formation des cavités fermées 3, sous vide, et étanches,
∘ une localisation de bornes de connexion 6a, 6b des éléments résistifs 4 dans des espaces creux 30 (notamment aussi fermés) délimités par les première et deuxième plaques 25, 28 et formés à l'extérieur des cavités fermées 3. On comprend alors que les bornes de connexion 6a, 6b peuvent être formées sur l'une des première ou deuxième plaques 25, 28 au préalable de l'étape d'assemblage.

On comprend de ce qui a été dit ci-dessus que les composants électroniques peuvent être formés à partir de deux plaques seulement, notamment en utilisant deux wafers par exemple en silicium. Sur un premier wafer les éléments résistifs et les premiers creux 23 sont formés et sur le deuxième wafer les deuxièmes creux 24 sont formés. Par wafer on entend dans la présente description une plaque de semi-conducteur. L'utilisation de deux plaques pour fabriquer la pluralité de composants électroniques permet de maintenir au final un vide contrôlé dans les cavités grâce à l'utilisation d'une seule soudure eutectique par cavité, contrairement à une multiplication des soudures - aussi appelées jonctions - eutectiques qui aurait pour conséquence de rendre plus difficile le contrôle de l'étanchéité des cavités fermées 3.

Les premiers et deuxièmes creux 23, 24 visés dans le cadre du procédé sont tels que ceux évoqués précédemment. Notamment, chaque premier creux 23 comporte une ouverture et un fond reliés par une paroi latérale dudit premier creux 23, la paroi latérale et le fond du premier creux 23 étant délimités par une surface continue en un même matériau, comme par exemple celui de la base 26. Par ailleurs, chaque deuxième creux 24 comporte une ouverture et un fond reliés par une paroi latérale dudit deuxième creux 24, la paroi latérale et le fond du deuxième creux 24 étant délimités par une surface continue en un même matériau, comme par exemple celui de la deuxième plaque 28.

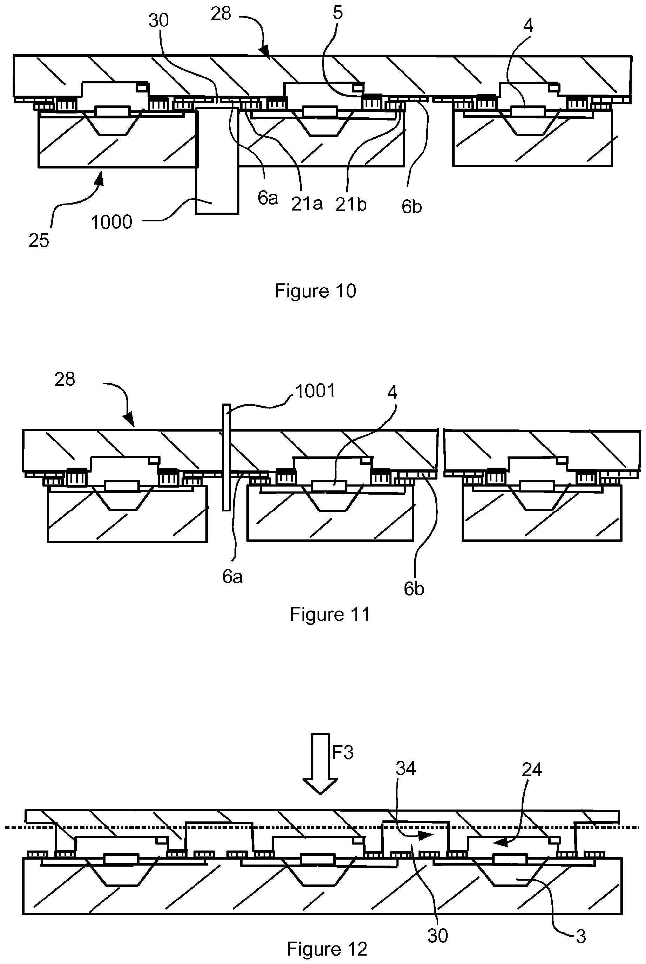

Ensuite, le procédé comporte (figure 6 et 10) une étape d'enlèvement de matière au niveau des espaces creux 30 pour rendre les bornes de connexion 6a, 6b accessibles. Aux figures 6 et 10, il est représenté une lame 1000 pour réaliser un sciage autorisant l'enlèvement de matière pour libérer les bornes de connexion 6a, 6b. L'enlèvement de matière au niveau des espaces creux 30 peut par exemple être réalisé en retirant, pour chaque espace creux, une partie de l'assemblage des première et deuxième plaques qui participe à délimiter ledit espace creux 30.

En fonction des applications, il est possible de rendre les composants individuels ou de les diviser en groupes solidaires les uns des autres. En ce sens, le procédé peut, le cas échéant, comporter une étape de séparation des composants électroniques par enlèvement de matière (figures 7 et 11).

De telles étapes sont avantageuses dans le sens où elles autorisent la formation des cavités fermées 3 en limitant la montée en température de l'ensemble des futurs composants électroniques tout en permettant de former l'ensemble des cavités des différents composants de manière simultanée à partir d'une même étape de soudage. Il en résulte qu'un tel procédé permet en outre la fabrication des composants électroniques selon une cadence adaptée à l'industrialisation et permettant par la même occasion de réduire les coûts de fabrication.

On comprend de ce qui a été dit ci-dessus que l'étape d'assemblage peut comporter (figures 5 et 9) en outre les étapes suivantes : une étape de placement des première et deuxième plaques 25, 28 dans l'enceinte 29, une étape d'alignement des première et deuxième plaques 25, 28, notamment pour que chaque premier creux puisse coopérer avec un deuxième creux correspondant en vue de former la cavité fermée correspondante, une étape de placement sous vide de l'enceinte 29 (notamment à une pression inférieure ou égale à celle indiquée précédemment et correspondant à celle à l'intérieur des cavités 3) comportant les première et deuxième plaques 25, 28 alignées. Une fois l'enceinte 29 placées sous vide, l'étape de soudage eutectique peut être mise en œuvre par thermocompression, en particulier en chauffant individuellement chacune des première et deuxième plaques 25, 28 lors de leur rapprochement. Le chauffage individuel des première et deuxième plaques 25, 28 permet notamment d'éviter la détérioration de l'élément résistif du fait d'une différence de température entre les deux plaques. Le chauffage individuel peut par exemple être mis en œuvre en utilisant deux éléments de chauffage 31, 32 disposés respectivement en contact avec la première plaque 25 et la deuxième plaque 28.

L'étape de soudage eutectique peut être mise en œuvre en soumettant l'ensemble formé par les première et deuxième plaques 25, 28 à une température comprise entre 350°C et 400°C, et notamment égale à 350°C.

L'étape de soudage eutectique utilise en particulier de l'or et du silicium mis en contact, mais d'autres matériaux tels que ceux listés précédemment (Au et In, ou Cu et Sn, ou Au et Sn, ou Au et Ge, ou Al et Ge) mis en contact peuvent être utilisés pour réaliser l'étape de soudage d'où il résulte la formation d'un alliage eutectique. Dans le cas Silicium/or, le silicium est préférentiellement issu de la deuxième plaque 28 et l'or de la première plaque 25. Selon un exemple particulier de mise en œuvre, le procédé de fabrication comporte (figure 4 et 8), au préalable de l'étape d'assemblage et pour chaque premier creux 23, une étape de formation de la piste 7 fermée en un premier matériau (notamment de l'or) agencée à la périphérie dudit premier creux 23. Cette piste 7 présente une épaisseur comprise entre 0,1 µm et 1 µm et notamment égale à 0,2 µm, et une largeur comprise entre 100 µm et 300 µm et notamment égale à 160 µm. Cette piste 7 doit être suffisamment large pour adsorber une éventuelle erreur d'alignement des première et deuxième plaques soit environ plus ou moins 0,1 degré à 0,2 degré sur 200mm soit environ 100 µm. Par ailleurs, la deuxième plaque 28 comporte des portées d'appui 33 (figures 4 et 8) en un deuxième matériau (notamment du silicium) disposées chacune en contact contre la piste 7 correspondante lors de l'étape d'assemblage (figures 5 et 9). Notamment, chaque piste 7 sera mise en contact avec une portée d'appui 33 associée de la deuxième plaque 28. Les premier et deuxième matériaux sont notamment choisis de sorte à former l'un des couple de matériaux suivants de l'or et du silicium, ou Cu et Sn, ou Au et Sn, ou Au et Ge, ou Al et Ge, ou Au et In. En fonction de la réalisation l'homme du métier saura adapter la présence des premier et deuxième matériaux au niveau des première et deuxième plaques 25, 28, par exemple en déposant si nécessaire des pistes complémentaires sur la deuxième plaque 28 pour former les portées d'appui 33. L'étape de soudage eutectique comporte alors une étape de sollicitation (flèches F1 et F2 aux figures 5 et 9) des première et deuxième plaques 25, 28 l'une vers l'autre en appliquant une température adaptée pour former la soudure eutectique 5 (figures 6 et 10) à partir des premier et deuxième matériaux. Les pistes 7 en particulier lorsqu'elles sont en or reposent notamment sur une couche de Si₃N₄ comme évoqué précédemment, cette couche de Si₃N₄ forme une barrière à la diffusion du matériau de la piste 7 vers d'autres couches du premier élément 1. Consécutivement à l'étape d'assemblage, les pistes 7, notamment en or, présentent une épaisseur amoindrie du fait de la soudure eutectique qui a formé un alliage, notamment SiAu, tout le long desdites pistes 7 (figures 6 et 10).

La libération des bornes de connexion 6a, 6b (figures 6 et 10) permet d'autoriser la connexion de ces bornes de connexion 6a, 6b à une source d'alimentation électrique pour activer l'élément résistif 4 associé, c'est-à-dire d'augmenter sa température à une température de fonctionnement désirée pour l'émission d'un rayonnement infrarouge souhaité hors de la cavité 3 associée. Bien entendu, cette libération sera préférentiellement mise en œuvre hors de l'enceinte 29 dans laquelle le soudage a été mis en œuvre.

La libération des bornes de connexion 6a, 6b (donc l'étape d'enlèvement de matière) peut être mise en œuvre de différentes manières, par exemple en utilisant les techniques de sciage, de gravure ou de polissage. Par sciage, il est possible d'enlever de la matière de l'ensemble formé au cours de l'étape d'assemblage à partir d'une lame. Par gravure sèche réactive (D-RIE pour l'anglais « Deep Reactive Ion Etching »), il est possible d'enlever de la matière de l'ensemble formé au cours de l'étape d'assemblage, mais dans ce cas les bornes de connexion 6a, 6b auront été, au préalable de l'étape d'assemblage, recouvertes par une couche d'oxyde (non représentée) pour les protéger en particulier lorsque ces dernières comportent de l'or. Par polissage, il pourra être utilisé la technique de planarisation mécano chimique aussi connue dans le domaine par CMP acronyme de l'anglais « Chemical Mechanical Polishing ».

Il a été décrit ci avant des premier et deuxième cas pour le positionnement des bornes de connexion 6a, 6b. Les figures 4 à 7 sont notamment liées au premier cas, et les figures 8 à 11 sont notamment liées au deuxième cas. Ceci aura bien entendu une influence quant aux étapes de fourniture des première et deuxième plaques 25, 28 dans le sens où ces bornes de connexion 6a, 6b seront portées, notamment avant l'étape d'assemblage, soit par la première plaque 25 (figures 4 à 7) soit par la deuxième plaque 28 (figures 8 à 10). Ces bornes de connexion seront préférentiellement en or ou en aluminium

Sur les figures 4 à 7, c'est la première plaque 25 qui comporte les bornes de connexion 6a, 6b des éléments résistifs 4, et l'étape d'enlèvement de matière pour libérer lesdites bornes de connexion 6a, 6b (figure 6) est mise en œuvre par enlèvement de matière appartenant à la deuxième plaque 28. Pour faciliter une telle mise en œuvre, la deuxième plaque 28 comporte des troisièmes creux 34 (figure 4) chacun destiné à former un espace creux 30 (figure 5) associé avec une partie de la première plaque 25 où est localisée au moins une des bornes de connexion 6a, 6b. Les troisièmes creux 34 sont (sauf s'ils sont situés à la périphérie de la deuxième plaque 28) chacun disposé entre un couple correspondant de deux deuxièmes creux 24 adjacents (figure 4). L'étape d'enlèvement de matière a donc lieu, pour chaque espace creux 30 au niveau d'une paroi dudit espace creux 30 située entre deux cavités fermées adjacentes 3 (figure 6). On notera que dans l'exemple de la figure 12 où l'on réalise un polissage selon la flèche F3, la profondeur des troisièmes creux 34 doit être supérieure à celles des deuxièmes creux 24 dans le sens où le polissage doit permettre l'ouverture des espaces creux 30 pour rendre accessible les bornes de connexion 6a, 6b mais sans préjudice à la fermeture des cavités 3 des différents composants électroniques : plus particulièrement, la ligne en pointillés à la figure 12 illustre là où l'on doit arrêter le polissage. Selon la réalisation des figures 4 à 7 et comme l'illustre plus particulièrement la figure 7, l'étape de séparation comporte l'enlèvement de matière appartenant à la première plaque 25, notamment par sciage par exemple à l'aide d'une lame 1001.

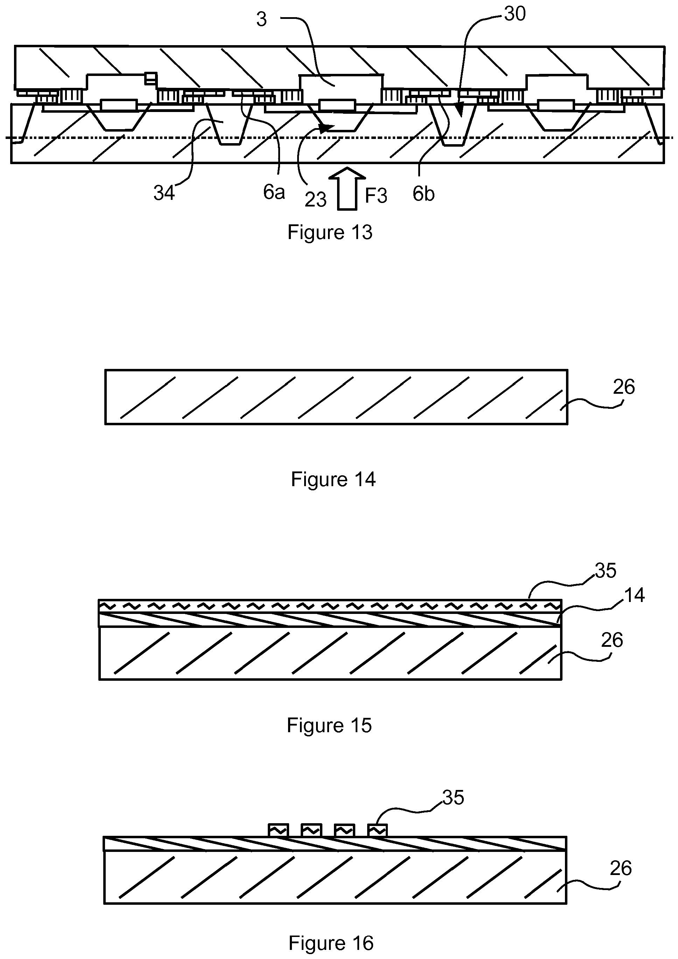

Les figures 8 à 11 illustrent le deuxième cas où les bornes de connexion 6a, 6b sont portées par la deuxième plaque 28 (notamment avant la mise en œuvre de l'étape d'assemblage), la première plaque 25 comporte des plots de connexion 21a, 21b (notamment en or ou en aluminium et portés par la première plaque avant la mise en œuvre de l'étape d'assemblage) chacun relié électriquement à au moins un élément résistif 4, et des troisièmes creux 34 (figure 8 et 9) destinés à former les espaces creux 30. Les troisièmes creux 34 sont chacun destinés à former un espace creux 30 associé avec une partie de la deuxième plaque 28 où est localisée au moins une des bornes de connexion 6a, 6b. Les troisièmes creux 34 sont (sauf s'ils sont disposés à la périphérie de la première plaque 25) chacun disposé entre un couple correspondant de deux premier creux 23 adjacents. Par ailleurs, il résulte de l'étape d'assemblage associée une mise en contact électrique des plots de connexion 21a, 21b avec les bornes de connexion 6a, 6b correspondantes (figure 9) et une formation des espaces creux 30 comprenant les bornes de connexion 6a, 6b. Généralement l'étape d'assemblage permet de réaliser un collage entre les plots de connexion et les bornes de connexion. Pour libérer les bornes de connexion 6a, 6b, l'étape d'enlèvement de matière peut être mise en œuvre par enlèvement de matière appartenant à la première plaque 25 (figure 10), par exemple en utilisant une lame 1000 au niveau des espaces creux 30. On notera que dans l'exemple utilisant le polissage illustré en figure 13, la profondeur des troisièmes creux 34 doit être supérieure à celle des premiers creux 23 dans le sens où le polissage doit permettre l'ouverture des espaces creux 30 pour rendre accessible les bornes de connexion 6a, 6b mais sans préjudice à la fermeture des cavités 3 des différents composants électroniques : plus particulièrement, la ligne en pointillés à la figure 13 illustre là où l'on doit arrêter le polissage selon la flèche F3. Selon la réalisation des figures 8 à 11 et comme l'illustre plus particulièrement la figure 11, l'étape de séparation comporte l'enlèvement de matière appartenant à la deuxième plaque 28, notamment par sciage par exemple à l'aide d'une lame 1001.

De manière générale, lorsque l'étape d'enlèvement de matière pour libérer les bornes de connexion 6a, 6b et l'étape de séparation des composants électroniques sont mises en œuvre par sciage, l'étape d'enlèvement de matière comporte l'utilisation d'une première lame 1000 (figures 6 et 10) présentant une première largeur de lame et l'étape de séparation des composants électroniques comporte l'utilisation d'une deuxième lame 1001 (figure 7 et 11) présentant une deuxième largeur inférieure à la première largeur.

Au cours du procédé, les futurs composants électroniques sont notamment espacés de telle manière que les espaces creux 30 situés entre deux cavités 3 fermées adjacentes comportent chacun des bornes de connexion de deux composants électroniques différents. Il en résulte qu'il est possible de maximiser ainsi le nombre de composants par plaque.

Dans la réalisation où un piège à gaz 19 est placé dans les cavités, celuici peut être formé dans le premier et/ou le deuxième creux (figures 4 et 8) au préalable de l'étape d'assemblage, et notamment l'étape de soudage permet concomitamment l'activation du piège à gaz 19 pour que ce dernier permette de participer à la mise sous vide des cavités 3.

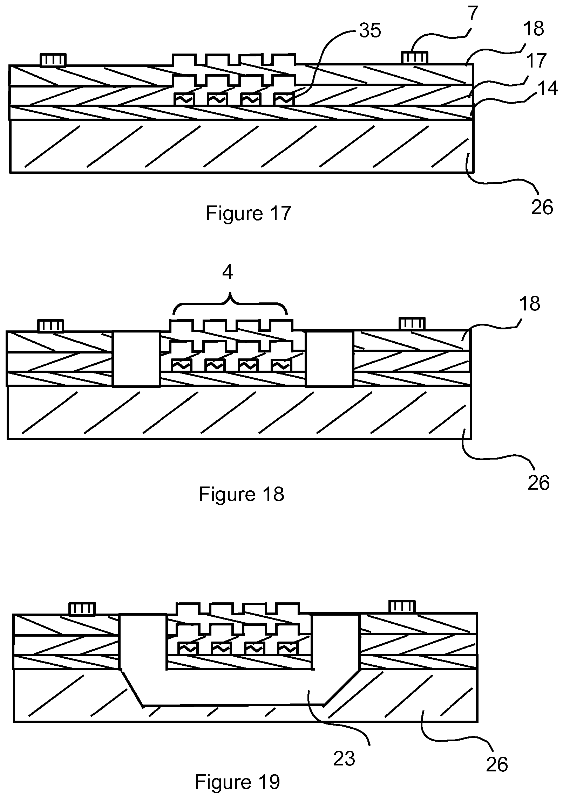

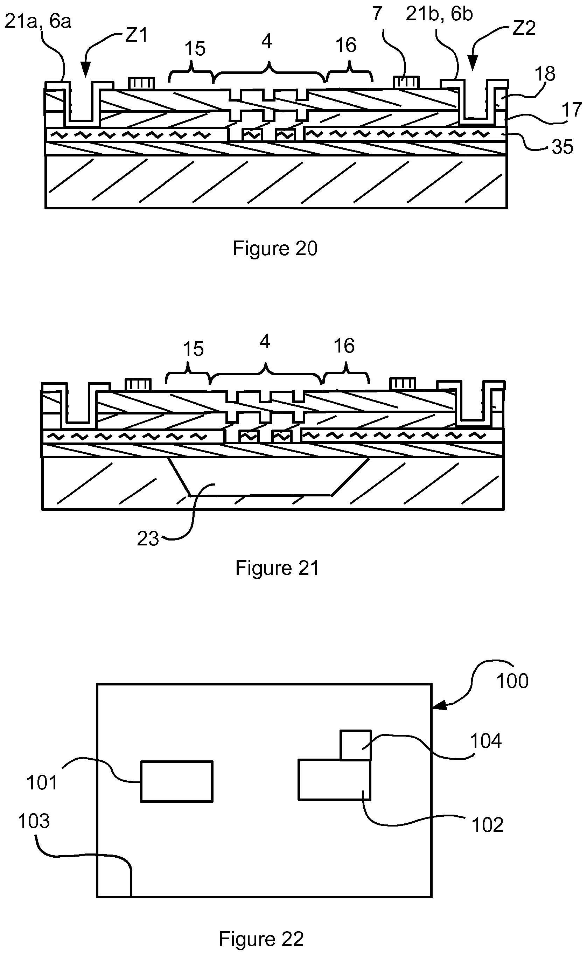

On comprend de toute ce qui a été dit précédemment que la première plaque peut être obtenue en formant à partir de la base de silicium une pluralité de sources par exemple telles que décrites dans le document « Sensors and Actuators A : Physical » dans l'article dont le titre est « Mid-IR source based on a free-standing microhotplate for autonomous CO2 sensing in indoor applications » de P. Barritault et al. Publié dans « Sensors and Actuators A 172 (2011) 379 - 385 » avant de former les pistes en or puis de reporter et de souder la deuxième plaque à la première plaque. A titre d'exemple, une étape de formation de la première plaque peut comporter les étapes suivantes illustrées en figures 14 à 21
- fournir une plaque/base préférentiellement de silicium 26 (figure 14),
- déposer une première couche 14 (figure 15) de relaxation des contraintes sur la plaque de silicium 26, notamment en Si₃N₄ (par exemple par dépôt LPCVD pour dépôt chimique en phase vapeur à basse pression ou en anglais « Low Pressure Chemical vapor déposition »),
- former un empilement 35 de couches sur la première couche 14 de relaxation comprenant une couche en métal disposées entre deux couches barrières à la diffusion de la couche en métal, cet empilement est notamment formé par les couches successives suivantes TiN/Pt/TiN (par exemple l'empilement est formé par dépôt PVD pour dépôt physique en phase vapeur),
- structurer (figure 16), par exemple par gravure ionique ou réactive, ledit empilement 35 de couches pour former au niveau de chaque futur composant électronique une partie dudit au moins un élément résistif 4 associé et une partie des futurs bras de suspension dudit au moins un élément résistif associé qui s'étendent alors jusqu'à des zones de reprise de contacts où pourront être formées selon le cas les plots ou bornes de connexion évoquées précédemment, en particulier, les parties électriquement conductrices des bras sont telles qu'elles sont moins résistives électriquement que l'élément résistif 4,
- déposer (figure 17) une couche de passivation 17, notamment en SiO₂ (par exemple par PECVD pour dépôt chimique en phase vapeur assisté par plasma ou en anglais « Plasma-enhanced chemical vapor déposition ») sur l'empilement structuré 35,
- déposer (figure 17) une deuxième couche 18 de relaxation des contraintes, notamment en Si₃N₄ (par exemple par LPCVD) sur la couche de passivation 17,
- graver (figure 20), par exemple par gravure réactive (RIE pour l'anglais « Reactive-ion etching ») la deuxième couche 18 de relaxation des contraintes et la couche de passivation 17 dans les zones Z1, Z2 de reprise de contact pour libérer l'accès électrique à l'empilement 35,
- former les pistes 7, en particulier en or, notamment à partir d'un dépôt par évaporation (figures 17 et 20) et les plots, ou le cas échéant les bornes de connexion, 21a, 21b, 6a, 6b. Les plots ou bornes de connexion pouvant être formés à partir du nitrure de titane de l'empilement 35 suivi d'un dépôt d'or. On notera que pour accélérer le procédé la piste en or 7 et au moins une partie en or des plots ou des bornes de connexion seront formées à partir d'un dépôt commun d'or. Le dépôt, notamment d'or, se fera préférentiellement par évaporation pour limiter la quantité de gaz piégé lors du dépôt,
- graver (figure 18), préférentiellement par gravure réactive (RIE), l'ensemble à partir de la deuxième couche de relaxation 18 des contraintes jusqu'à la plaque de silicium 26 de telle manière à délimiter les éléments résistifs 4 (figure 18) ainsi que les parties des bras de suspension 15, 16 associés (figure 20) et destinées à être disposées dans les futures cavités fermées,
- graver (figures 19 et 21) la base/plaque en silicium 26 par exemple par gravure chimique anisotrope (notamment selon les techniques TMAH (pour « Tetramethylammonium Hydroxyde ») ou KOH (pour « Potassium Hydroxide »), avec une préférence pour TMAH du fait de sa bonne compatibilité avec la microélectronique) d'où il résulte la formation des premier creux 23 et la suspension des éléments résistifs 4, notamment via leurs bras 15, 16 au-dessus des premiers creux 23.

Pour généraliser, le procédé peut comporter, avant la fourniture de la première plaque 25, une étape de formation de la première plaque 25, cette étape de formation de la première plaque comportant :
- une étape de fourniture d'une base 26 se présentant sous la forme d'une plaque, par exemple une plaque de silicium ou wafer,
- une étape de formation des éléments résistifs 4 sur cette base 26, notamment sur une face de cette base, lesdits éléments résistifs étant destinés à former des sources de rayonnement infrarouge,
- une étape de gravure de la base 26 du côté de la face de la base 26 où sont formés les éléments résistifs 4 de sorte à former les premiers creux 23 dans la base 26. Autrement dit, l'étape de gravure permet de suspendre les éléments résistifs postérieurement à leur formation.

Il résulte des étapes précédentes que chaque piste en or 7 repose sur une couche de Si₃N₄. Les figures 14 à 21 montre la réalisation d'une partie d'un seul composant, mais ces étapes réalisées sur l'ensemble d'une plaque de silicium 26 en utilisant des techniques microélectronique peuvent permettre la formation concomitante d'une pluralité de premier creux associés chacun à au moins un élément résistif suspendu. Concernant les épaisseurs des différentes couches utilisées elles correspondent à celles décrites précédemment dans le cadre du composant électronique. Quant à la deuxième plaque, elle peut être obtenue à partir d'une plaque de silicium structurée de manière adaptée pour former les deuxièmes creux 24 et le cas échéant les troisièmes creux 34. Cette structuration peut être mise en œuvre par exemple par gravure chimique ou réactive.

La présente invention permet d'encapsuler une source infrarouge à émetteur à résistance métallique tout en autorisant le positionnement des bornes de connexion aisément sans limitation en face arrière ou avant. Le procédé décrit est :
- compatible avec l'utilisation de couches métalliques,
- capable de garantir un scellement étanche et capable de garantir la mise sous vide pour une longue période,
- capable de transférer les connections d'alimentation de la résistance à l'extérieur du volume sous vide,
- apte à proposer des bornes de connexion de l'élément résistif soit en face avant soit en face arrière du composant électronique.

Par ailleurs, le procédé permet de protéger de manière étanche, collective et sous vide un ensemble d'éléments résistifs à couche résistive métallique formés sur une plaque de silicium commune tout en permettant une découpe individuelle des composants électroniques.

Il résulte d'une telle invention avec un placement sous vide de l'élément résistif 4 que la consommation électrique du composant électronique est réduite d'un facteur 10 par rapport au même composant électronique mais dont l'élément résistif ne serait pas placé sous vide.

L'invention est aussi relative à une utilisation d'un composant électronique tel que décrit en tant que source de rayonnement infrarouge pour la détection de gaz.

L'invention est bien entendu aussi relative à un détecteur de gaz 100 (figure 22) comprenant un composant électronique 101 tel que décrit et un capteur de mesure 102 apte à mesurer un rayonnement infrarouge issu du composant électronique 101. En particulier, le détecteur de gaz 100 comporte une cavité optique 103 dans laquelle sont placés le composant électronique 101 et le capteur 102. Le détecteur de gaz peut comporter un module d'analyse 104 relié au capteur 102, et apte à déterminer la présence d'un gaz à partir d'une mesure de l'intensité du rayonnement capté. Notamment, les gaz pouvant être détectés par le détecteur de gaz sont HF, HCl, SO₂, SO₃, CO₂, HBr, H₂S, C₂H₆, C₃H₈, C₄H₁₀, NO, COCL₂, BF₃, NO₂, CH₄, HNO₃, un composé organique volatil par exemple CH₃COCH₃, B₂H₆, CO, CS₂, HCN, WF₆, N₂O, NH₃, AsH₃, un hydrocarbure aromatique polycyclique, le benzène, le toluène, les trois isomères du xylène, C₂H₄O, BCl_{3.}

Les détecteurs de gaz trouvent souvent application dans la gestion dynamique des systèmes de la climatisation et dans la prévention des accidents domestiques liés aux disfonctionnements des moyens de chauffage à gaz/fuel/bois (risques d'explosion suite aux fuites de gaz, occlusion des cheminées, et production de CO en excès, etc.) Si la concentration de CO₂ est un bon indicateur du taux d'occupation et du taux de renouvellement de l'air, le CO est extrêmement toxique. D'autre part, le butane, le propane et le méthane, généralement comme utilisé comme gaz domestiques, sont explosifs quand leur concentration dépasse quelques % (-2% pour butane et propane, -5% pour méthane). Il y a donc une réelle nécessité à l'utilisation des détecteurs de gaz.

Les gaz ont des signatures spectrales bien marquées dans l'infrarouge (vibrations des molécules), rendant ainsi possible la détection sur des bande spectrales d'absorption caractéristiques du gaz recherché par exemple en utilisant la bande spectrale d'absorption autour de 4,25 µm du CO₂ pour le détecter.

Le composant électronique peut éventuellement intégrer un élément filtrant et/ou antireflet. L'élément filtrant permet de sélectionner la bande spectrale caractéristique du composé que l'on cherche à détecter, par exemple pour du CO₂ on prendra de 4,25 µm plus ou moins 100nm. Concernant l'élément anti reflet, il permet d'adapter l'indice optique des matériaux utilisés dans le cadre du détecteur, l'élément anti-reflet peut par exemple comporter une ou plusieurs couches (ex. SiO₂, Si₃N₄) présentant des épaisseurs variables en fonction de la longueur d'onde et comprises entre quelques dizaines de nm et quelques centaines de nm.

## Revendications

1. Composant électronique pour générer un rayonnement infrarouge, **caractérisé en ce qu'**il comprend un premier élément (1) et un deuxième élément (2) agencés de sorte à former une cavité (3) fermée et sous vide dans laquelle au moins un élément résistif (4) dudit composant électronique est suspendu, ledit au moins un élément résistif (4) comprenant du métal, lesdits premier et deuxième éléments (1, 2) étant liés par soudure eutectique (5) permettant de fermer de façon étanche la cavité (3), ledit composant électronique comportant des bornes de connexion (6a, 6b) situées à l'extérieur de la cavité fermée (3) et reliées électriquement à l'élément résistif (4) suspendu, et **en ce que** la cavité fermée (3) présente une pression interne inférieure à 10⁻² mbar, et notamment comprise entre 10⁻³ mbar et 10⁻² mbar, et **en ce que** l'élément résistif (4) est suspendu par des bras de suspension (15, 16) appartenant au premier élément (1).

2. Composant électronique selon la revendication précédente, **caractérisé en ce que** la soudure eutectique (5) est réalisée avec du silicium et de l'or, ou Au et In, ou Cu et Sn, ou Au et Sn, ou Au et Ge, ou Al et Ge.

3. Composant électronique selon l'une quelconque des revendications précédentes, **caractérisé en ce qu'**un piège à gaz (19) résiduels est situé dans la cavité fermée (3).

4. Composant électronique selon l'une quelconque des revendications précédentes, **caractérisé en ce que** le premier élément (1) comporte les bornes de connexion (6a, 6b).

5. Composant électronique selon l'une quelconque des revendications 1 à 3, **caractérisé en ce que** le deuxième élément (2) comporte les bornes de connexion (6a, 6b), le premier élément (1) comporte des plots (21a, 21b) de connexion reliés électriquement à l'élément résistif (4), les bornes de connexion (6a, 6b) étant chacune en contact électrique avec au moins un des plots (21a, 21b) de connexion.

6. Composant électronique selon l'une quelconque des revendications précédentes, **caractérisé en ce que** l'élément résistif (4) comporte au moins une partie structurée d'un empilement comprenant les couches successives suivantes : une première couche barrière (11) à la diffusion d'une couche en métal (12), la couche en métal (12) notamment en platine, une deuxième couche barrière (13) à la diffusion de la couche en métal (12), préférentiellement les première et deuxième couches barrières (12, 13) sont en nitrure de titane.

7. Composant électronique selon la revendication 6, **caractérisé en ce que** ledit empilement forme une partie des bras de suspension (15, 16) de l'élément résistif (4) et s'étend en direction des bornes de connexion (6a, 6b).

8. Composant électronique selon l'une quelconque des revendications précédentes, **caractérisé en ce que** la fermeture de la cavité fermée (3) est assurée par un unique cordon de soudure eutectique.

9. Composant électronique selon l'une quelconque des revendications précédentes, **caractérisé en ce que** la cavité fermée (3) est délimitée au moins en partie par un creux formé dans le premier élément, ledit creux comportant un fond orienté vers l'élément résistif (4), ledit creux étant délimité par une surface continue d'un même matériau.

10. Procédé de fabrication d'une pluralité de composants électroniques selon l'une quelconque des revendications précédentes, **caractérisé en ce qu'**il comporte les étapes suivantes :
- une étape de fourniture d'une première plaque (25) comprenant une base, préférentiellement en silicium (26), au niveau de laquelle est formée une pluralité de premiers creux (23), ladite première plaque (25) comprenant des éléments résistifs (4) suspendus comprenant du métal, et chaque premier creux (23) est associé à au moins un des éléments résistifs (4) suspendus et disposé en regard du fond dudit premier creux (23),
- une étape de fourniture d'une deuxième plaque (28), préférentiellement formée en tout ou partie par du silicium, comportant des deuxièmes creux (24) destinés à coopérer avec lesdits premiers creux (23) en vue de former les cavités fermées (3) des composants électroniques,
- une étape d'assemblage des première et deuxième plaques (25, 28) comportant une étape de soudage eutectique mise en œuvre dans une enceinte sous vide (29) d'où il résulte :
∘ une formation des cavités fermées (3), sous vide, et étanches,
∘ une localisation de bornes de connexion (6a, 6b) des éléments résistifs (4) dans des espaces creux (30) délimités par les première et deuxième plaques (25, 28) et formés à l'extérieur des cavités fermées (3),
- une étape d'enlèvement de matière au niveau des espaces creux (30) pour rendre les bornes de connexion (6a, 6b) accessibles.

11. Procédé selon la revendication 10, **caractérisé en ce que** l'étape de soudage eutectique utilise de l'or et du silicium, ou Cu et Sn, ou Au et Sn, ou Au et Ge, ou Al et Ge, ou Au et In, mis en contact.

12. Procédé selon l'une quelconque des revendications 10 à 11, **caractérisé en ce qu'**il comporte au préalable de l'étape d'assemblage, pour chaque premier creux (23), une étape de formation d'une piste fermée en un premier matériau, préférentiellement de l'or, agencée à la périphérie dudit premier creux (23), et **en ce que** la deuxième plaque (28) comporte des portées d'appui (33) en un deuxième matériau, préférentiellement du silicium, disposées chacune en contact contre la piste (7) correspondante lors de l'étape d'assemblage, l'étape de soudage eutectique comportant une étape de sollicitation des première et deuxième plaques (25, 28) l'une vers l'autre en appliquant une température adaptée pour former la soudure eutectique (5) à partir des premier et deuxième matériaux.

13. Procédé selon l'une quelconque des revendications 10 à 12, **caractérisé en ce que** la première plaque (25) comporte les bornes de connexion (6a, 6b), et **en ce que** l'étape d'enlèvement de matière est mise en œuvre par enlèvement de matière appartenant à la deuxième plaque (28), et **en ce que** l'étape d'enlèvement de matière est mise en œuvre par une des techniques choisies parmi : un sciage, un polissage, une gravure.

14. Procédé selon l'une quelconque des revendications 10 à 12, **caractérisé en ce que** :
• les bornes de connexion (6a, 6b) sont portées par la deuxième plaque (28),
• la première plaque (25) comporte des plots de connexion (21a, 21b) chacun relié électriquement à au moins un élément résistif (4), et des troisièmes creux (34) destinés à former les espaces creux (30),
• il résulte de l'étape d'assemblage une mise en contact électrique des plots de connexion (21a, 21b) avec les bornes de connexion (6a, 6b) correspondantes et une formation des espaces creux (30) comprenant les bornes de connexion (6a, 6b).

15. Détecteur de gaz comprenant un composant électronique (101) selon l'une quelconque des revendications 1 à 9 et un capteur (102) apte à mesurer un rayonnement infrarouge issu du composant électronique (101).

## Patentansprüche

1. Elektronische Komponente zum Erzeugen einer Infrarotstrahlung, **dadurch gekennzeichnet, dass** sie ein erstes Element (1) und ein zweites Element (2) beinhaltet, die so angeordnet sind, dass sie einen geschlossenen und unter Vakuum stehenden Hohlraum (3) bilden, in dem mindestens ein Widerstandselement (4) der elektronischen Komponente aufgehängt ist, wobei das mindestens eine Widerstandselement (4) Metall beinhaltet, wobei das erste und zweite Element (1, 2) durch eine eutektische Lötverbindung (5) verbunden sind, die es gestattet, den Hohlraum (3) dicht zu verschließen, wobei die elektronische Komponente Anschlusselemente (6a, 6b) umfasst, die sich außerhalb des geschlossenen Hohlraums (3) befinden und mit dem aufgehängten Widerstandselement (4) elektrisch verbunden sind, und dass der geschlossene Hohlraum (3) einen Innendruck aufweist, der kleiner als 10⁻² mbar ist und insbesondere zwischen 10⁻³ mbar und 10⁻² mbar liegt, und dass das Widerstandselement (4) an Aufhängungsarmen (15, 16), die zu dem ersten Element (1) gehören, aufgehängt ist.

2. Elektronische Komponente nach dem vorhergehenden Anspruch, **dadurch gekennzeichnet, dass** die eutektische Lötverbindung (5) aus Silicium und Gold oder Au und In oder Cu und Sn oder Au und Sn oder Au und Ge oder Al und Ge hergestellt ist.

3. Elektronische Komponente nach einem der vorhergehenden Ansprüche, **dadurch gekennzeichnet, dass** sich in dem geschlossenen Hohlraum (3) ein Restgasfänger (19) befindet.

4. Elektronische Komponente nach einem der vorhergehenden Ansprüche, **dadurch gekennzeichnet, dass** das erste Element (1) die Anschlusselemente (6a, 6b) umfasst.

5. Elektronische Komponente nach einem der Ansprüche 1 bis 3, **dadurch gekennzeichnet, dass** das zweite Element (2) die Anschlusselemente (6a, 6b) umfasst, das erste Element (1) Anschlussflächen (21a, 21b) umfasst, die mit dem Widerstandselement (4) elektrisch verbunden sind, wobei die Anschlusselemente (6a, 6b) jeweils mit mindestens einer der Anschlussflächen (21a, 21b) elektrisch in Kontakt stehen.

6. Elektronische Komponente nach einem der vorhergehenden Ansprüche, **dadurch gekennzeichnet, dass** das Widerstandselement (4) mindestens einen strukturierten Abschnitt eines Stapels umfasst, der die folgenden aufeinanderfolgenden Schichten beinhaltet: eine erste Diffusionssperrschicht (11) für eine Metallschicht (12), wobei die Metallschicht (12) insbesondere aus Platin ist, eine zweite Diffusionssperrschicht (13) für die Metallschicht (12), wobei die erste und zweite Sperrschicht (12, 13) vorzugsweise aus Titannitrid sind.

7. Elektronische Komponente nach Anspruch 6, **dadurch gekennzeichnet, dass** der Stapel einen Abschnitt der Aufhängungsarme (15, 16) des Widerstandselements (4) bildet und sich in Richtung der Anschlusselemente (6a, 6b) erstreckt.

8. Elektronische Komponente nach einem der vorhergehenden Ansprüche, **dadurch gekennzeichnet, dass** das Schließen des geschlossenen Hohlraums (3) durch eine einzige eutektische Lötverbindungsnaht gewährleistet wird.

9. Elektronische Komponente nach einem der vorhergehenden Ansprüche, **dadurch gekennzeichnet, dass** der geschlossene Hohlraum (3) mindestens teilweise durch eine in dem ersten Element gebildete Vertiefung begrenzt wird, wobei die Vertiefung einen Boden umfasst, der zu dem Widerstandselement (4) zeigt, wobei die Vertiefung durch eine durchgehende Oberfläche aus einem gleichem Material begrenzt wird.

10. Verfahren zur Fertigung einer Vielzahl von elektronischen Komponenten nach einem der vorhergehenden Ansprüche, **dadurch gekennzeichnet, dass** es die folgenden Schritte umfasst:
- einen Schritt des Bereitstellens einer ersten Platte (25), die eine Basis vorzugsweise aus Silicium (26) beinhaltet, in der eine Vielzahl von ersten Vertiefungen (23) gebildet ist, wobei die erste Platte (25) aufgehängte Widerstandselemente (4), die Metall beinhalten, beinhaltet, und wobei jede erste Vertiefung (23) mit mindestens einem der aufgehängten Widerstandselemente (4) assoziiert ist, das gegenüber dem Boden der ersten Vertiefung (23) angeordnet ist,
- einen Schritt des Bereitstellens einer zweiten Platte (28), die vorzugsweise ganz oder teilweise aus Silicium gebildet ist und zweite Vertiefungen (24) umfasst, die dazu bestimmt sind, mit den ersten Vertiefungen (23) zusammenzuwirken, um die geschlossenen Hohlräume (3) der elektronischen Komponenten zu bilden,
- einen Schritt des Zusammenbauens der ersten und zweiten Platte (25, 28), umfassend einen Schritt des eutektischen Lötens, der in einer Vakuumkammer (29) umgesetzt wird, was zu Folgendem führt:
o Bildung der geschlossenen, unter Vakuum stehenden und dichten Hohlräume (3),
o Platzierung von Anschlusselementen (6a, 6b) der Widerstandselemente (4) in Aushöhlungen (30), die durch die erste und zweite Platte (25, 28) begrenzt werden und außerhalb der geschlossenen Hohlräume (3) gebildet sind,
- einen Schritt des Entfernens von Material im Bereich der Aushöhlungen (30), um Zugang zu den Anschlusselementen (6a, 6b) zu erhalten.

11. Verfahren nach Anspruch 10, **dadurch gekennzeichnet, dass** der Schritt des eutektischen Lötens Gold und Silicium oder Cu und Sn oder Au und Sn oder Au und Ge oder Al und Ge oder Au und In verwendet, die in Kontakt gebracht werden.

12. Verfahren nach einem der Ansprüche 10 bis 11, **dadurch gekennzeichnet, dass** es vor dem Schritt des Zusammenbauens für jede Vertiefung (23) einen Schritt des Bildens einer geschlossenen Bahn aus einem ersten Material, vorzugsweise Gold, umfasst, die am Umfang der ersten Vertiefung (23) angeordnet wird, und dass die zweite Platte (28) Auflageflächen (33) aus einem zweiten Material, vorzugsweise Silicium, umfasst, die während des Schritts des Zusammenbauens jeweils in Kontakt mit der entsprechenden Bahn (7) angeordnet werden, wobei der Schritt des eutektischen Lötens einen Schritt des Spannens der ersten und zweiten Platte (25, 28) gegeneinander unter Anwendung einer geeigneten Temperatur umfasst, um die eutektische Lötverbindung (5) auf Basis des ersten und zweiten Materials zu bilden.

13. Verfahren nach einem der Ansprüche 10 bis 12, **dadurch gekennzeichnet, dass** die erste Platte (25) die Anschlusselemente (6a, 6b) umfasst und dass der Schritt des Entfernens von Material durch das Entfernen von Material, das zu der zweiten Platte (28) gehört, umgesetzt wird und dass der Schritt des Entfernens von Material durch eine der Techniken umgesetzt wird, die aus Folgendem ausgewählt wird: Sägen, Polieren, Ätzen.

14. Verfahren nach einem der Ansprüche 10 bis 12, **dadurch gekennzeichnet, dass**:
• die Anschlusselemente (6a, 6b) von der zweiten Platte (28) getragen werden,
• die erste Platte (25) Anschlussflächen (21a, 21b), die jeweils mit mindestens einem Widerstandselement (4) elektrisch verbunden sind, und dritte Vertiefungen (34), die dazu bestimmt sind, die Aushöhlungen (30) zu bilden, umfasst,
• sich aus dem Schritt des Zusammenbauens eine elektrische Kontaktierung der Anschlussflächen (21a, 21b) mit den entsprechenden Anschlusselementen (6a, 6b) und eine Bildung der Aushöhlungen (30), die die Anschlusselemente (6a, 6b) beinhalten, ergibt.

15. Gasdetektor, der eine elektronische Komponente (101) nach einem der Ansprüche 1 bis 9 und einen Sensor (102), der dazu fähig ist, eine von der elektronischen Komponente (101) ausgehende Infrarotstrahlung zu messen, beinhaltet.

## Claims

1. Electronic component for generating infrared radiation, **characterized in that** it comprises a first element (1) and a second element (2) arranged in such a manner as to form an enclosed cavity (3) under vacuum within which at least one resistive element (4) of the said electronic component is suspended, said at least one resistive element (4) comprising metal, the said first and second elements (1, 2) being joined by eutectic soldering (5) allowing the cavity (3) to be sealed in a leak-tight manner, said electronic component comprising connection terminals (6a, 6b) situated outside of the enclosed cavity (3) and electrically connected to the suspended resistive element (4), and **in that** the enclosed cavity (3) has an internal pressure of less than 10⁻² mbar, and notably comprised between 10⁻³ mbar and 10⁻² mbar, and **in that** the resistive element (4) is suspended by suspension arms (15, 16) belonging to the first element (1).

2. Electronic component according to the preceding claim, **characterized in that** the eutectic soldering (5) is formed with silicon and gold, or Au and In, or Cu and Sn, or Au and Sn, or Au and Ge, or Al and Ge.

3. Electronic component according to any one of the preceding claims, **characterized in that** a residual gas trap (19) is situated within the enclosed cavity (3).

4. Electronic component according to any one of the preceding claims, **characterized in that** the first element (1) comprises the connection terminals (6a, 6b).

5. Electronic component according to any one of Claims 1 to 3, **characterized in that** the second element (2) comprises the connection terminals (6a, 6b), the first element (1) comprises connection pads (21a, 21b) electrically connected to the resistive element (4), the connection terminals (6a, 6b) each being in electrical contact with at least one of the connection pads (21a, 21b).

6. Electronic component according to any one of the preceding claims, **characterized in that** the resistive element (4) comprises at least one structured part of a stack comprising the following successive layers: a first barrier layer (11) against the diffusion of a metal layer (12), the metal layer (12) notably of platinum, a second barrier layer (13) against the diffusion of the metal layer (12), preferably the first and second barrier layers (12, 13) are of titanium nitride.

7. Electronic component according to Claim 6, **characterized in that** said stack forms a part of the suspension arms (15, 16) of the resistive element (4) and extends in the direction of the connection terminals (6a, 6b).

8. Electronic component according to any one of the preceding claims, **characterized in that** the closure of the enclosed cavity (3) is provided by a single ribbon of eutectic soldering.

9. Electronic component according to any one of the preceding claims, **characterized in that** the enclosed cavity (3) is bounded, at least in part, by a hollow formed in the first element, said hollow comprising a bottom oriented towards the resistive element (4), said hollow being bounded by a continuous surface of the same material.

10. Method of fabrication of a plurality of electronic components according to any one of the preceding claims, **characterized in that** it comprises the following steps:
- a step for supplying a first plate (25) comprising a base, preferably made of silicon (26), on which a plurality of first hollows (23) is formed, the said first plate (25) comprising suspended resistive elements (4) comprising metal, and each first hollow (23) is associated with at least one of the suspended resistive elements (4) and disposed facing the bottom of the said first hollow (23),
- a step for supplying a second plate (28), preferably formed, entirely or in part, of silicon, comprising second hollows (24) intended to cooperate with the said first hollows (23) for the purpose of forming the enclosed cavities (3) of the electronic components,
- a step for assembling the first and second plates (25, 28) comprising a step for eutectic soldering implemented within a chamber under vacuum (29) which results in:
∘ formation of the enclosed cavities (3), under vacuum and leak tight,
∘ localization of connection terminals (6a, 6b) of the resistive elements (4) in hollow spaces (30) bounded by the first and second plates (25, 28) and formed outside of the enclosed cavities (3),
- a step for removal of material in the hollow spaces (30) in order to make the connection terminals (6a, 6b) accessible.

11. Method according to Claim 10, **characterized in that** the step for eutectic soldering uses gold and silicon, or Cu and Sn, or Au and Sn, or Au and Ge, or Al and Ge, or Au and In, brought into contact.

12. Method according to any one of Claims 10 to 11, **characterized in that** it comprises, prior to the assembly step, for each first hollow (23), a step for formation of a closed track made of a first material, preferably gold, arranged at the periphery of the said first hollow (23), and **in that** the second plate (28) comprises bearing faces (33) made of a second material, preferably silicon, each disposed in contact against the corresponding track (7) during the assembly step, the eutectic soldering step comprising a step for pushing the first and second plates (25, 28) towards each other while applying a suitable temperature in order to form the eutectic soldering (5) from the first and second materials.

13. Method according to any one of Claims 10 to 12, **characterized in that** the first plate (25) comprises the connection terminals (6a, 6b), and **in that** the step for removal of material is implemented by removal of material belonging to the second plate (28), and **in that** the step for removal of material is implemented by one of the techniques chosen from amongst: sawing, polishing, etching.

14. Method according to any one of Claims 10 to 12, **characterized in that**:
• the connection terminals (6a, 6b) are carried by the second plate (28),
• the first plate (25) comprises connection pads (21a, 21b) each electrically connected to at least one resistive element (4), and third hollows (34) intended to form the hollow spaces (30),
• the result of the assembly step is an electrical contact being made between the connection pads (21a, 21b) and the corresponding connection terminals (6a, 6b) and the formation of the hollow spaces (30) comprising the connection terminals (6a, 6b).

15. Gas detector comprising an electronic component (101) according to any one of Claims 1 to 9 and a sensor (102) capable of measuring infrared radiation coming from the electronic component (101).
